(19) Europäisches Patentamt
European Patent Office
Office européen des brevets

(11) **EP 4 366 147 A1**

(12) **EUROPEAN PATENT APPLICATION**
published in accordance with Art. 153(4) EPC

(43) Date of publication:
**08.05.2024 Bulletin 2024/19**

(21) Application number: **22855714.6**

(22) Date of filing: **23.03.2022**

(51) International Patent Classification (IPC):
**H02M 1/08** (2006.01)   **H02M 3/155** (2006.01)

(52) Cooperative Patent Classification (CPC):
**H02M 1/08; H02M 3/155;** Y02B 70/10

(86) International application number:
**PCT/JP2022/013581**

(87) International publication number:
**WO 2023/017648 (16.02.2023 Gazette 2023/07)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.08.2021 JP 2021131641**

(71) Applicant: OMRON Corporation
**Kyoto 600-8530 (JP)**

(72) Inventors:
• **NOSAKA, Noriyuki**
  **Kyoto-shi, Kyoto 600-8530 (JP)**
• **OKADA, Wataru**
  **Kyoto-shi, Kyoto 600-8530 (JP)**
• **TAUCHI, Hironori**
  **Kyoto-shi, Kyoto 600-8530 (JP)**
• **IWAI, Satoshi**
  **Kyoto-shi, Kyoto 600-8530 (JP)**

(74) Representative: **Isarpatent**
**Patent- und Rechtsanwälte
Barth Hassa Peckmann & Partner mbB
Friedrichstraße 31
80801 München (DE)**

(54) **DRIVE CIRCUIT FOR SWITCHING ELEMENT AND SWITCHING CIRCUIT**

(57) A gate drive circuit connected to a gate terminal and a source terminal of a first switching element and turns on and off the first switching element, the gate drive circuit includes: a controller that has a first terminal connected to the gate terminal and a second terminal connected to the source terminal, has a first switch provided between the first terminal and a voltage source, and a second switch provided between the first terminal and the second terminal; a first resistor and a first capacitor, each having one end connected to the gate terminal and the other end connected to the first terminal; a second capacitor that has one end connected to the source terminal and the other end connected to the second terminal; and a first Zener diode that has a cathode terminal connected to the source terminal and an anode terminal connected to the second terminal.

Fig. 1

EP 4 366 147 A1

**Description**

TECHNICAL FIELD

The present invention relates to a drive circuit for a switching element and a switching circuit including the same.

BACKGROUND ART

Conventionally, there has been proposed a technique that uses a junction field-effect transistor (JFET) or the like made of silicon carbide (SiC) as a switching element in a power converter or the like. In such a drive circuit for a switching element, to prevent malfunction, a capacitor, having a capacitance larger than a stray capacitance generated between the drain and the gate of the switching element, is provided between the gate and the source. Furthermore, to prevent malfunction, a technique for achieving negative biasing by using a speed-up capacitor CgD has been proposed (see, for example, Patent Document 1). Similarly, a technique for achieving negative biasing by using a Zener diode has also been proposed (see, for example, Patent Document 2).

Here, a negative bias voltage in the drive circuit of the conventional switching element as described above sometimes causes disadvantages of an increase in the gate surge of the switching element and an increase in reverse conduction loss due to the internal diode.

PRIOR ART DOCUMENT

PATENT DOCUMENTS

Patent Document 1: Japanese Unexamined Patent Publication No. 2013-99133
Patent Document 2: Japanese Unexamined Patent Publication No. 2014-93586

SUMMARY OF THE INVENTION

PROBLEMS TO BE SOLVED BY THE INVENTION

The present invention has been made in view of the above problems, and an object of the present invention is to provide a technique capable of reducing a gate surge of a switching element and reducing a reverse conduction loss in the gate drive circuit of the switching element.

MEANS FOR SOLVING THE PROBLEM

The present invention for solving the above problems is a gate drive circuit that is connected to a gate terminal and a source terminal of a first switching element and turns on and off the first switching element, the gate drive circuit including: a controller that includes a first terminal connected to the gate terminal and a second terminal connected to the source terminal, includes a first switch provided between the first terminal and a voltage source, and a second switch provided between the first terminal and the second terminal, and is configured to close the first switch to supply a current from the first terminal to the gate terminal; a first resistor and a first capacitor, each having one end connected to the gate terminal and the other end connected to the first terminal, the first resistor and the first capacitor being connected in parallel to each other; a second capacitor that has one end connected to the source terminal and the other end connected to the second terminal; and a first Zener diode that has a cathode terminal connected to the source terminal and an anode terminal connected to the second terminal, and is connected in parallel to the second capacitor.

According to the present invention, the input capacitances of the first capacitor, the second capacitor, and the first switching element are charged by the current supplied from the first terminal of the controller to the gate terminal when the first switching element is turned on, and the accumulated charge is discharged via the first resistor when the first switching element is gate-off, whereby a negative bias voltage is applied to the first switching element. The negative bias voltage applied in this manner does not rapidly increase when the first switching element is turned off, thereby enabling a reduction in the gate surge of the first switching element and a reduction in reverse conduction loss.

Further, in the present invention, a mirror clamp circuit is provided between the gate terminal as one side and the one end of the first resistor and the one end of the first capacitor together as another side, and between the second terminal as one side and the other end of the second capacitor and the anode terminal of the first Zener diode together as another side.

In this way, the gate voltage of the first switching device can be held low when the switching noise of the first switching element occurs, and a large voltage such as a surge voltage can be prevented from being applied.

Further, in the present invention, the mirror clamp circuit includes a second switching element that is turned on when a voltage vqs between the gate terminal as one side and the one end of the first resistor and the one end of the first capacitor together as another side, and between the second terminal as one side and the other end of the second capacitor and the anode terminal of the first Zener diode together as another side becomes equal to or lower than a threshold voltage Vth. When the first switching element sequentially transitions through a plurality of modes that include a first mode during which an input capacitance of the first switching element is charged and the first switching element is turned on and a second mode during which the first switch is turned off, the second switch is turned on, and the first switching element is turned off, the following mathematical expression is satisfied, where a voltage across and a capacitance of the first capacitance are vcp and Cp, respectively, a voltage across and a capacitance of the second capacitance are vcs and Cs, respectively, a gate charge amount and an input capacitance of the first switching element are Qg and Ciss, respectively, vcp and vcs at the end of the first mode are vcp_1 and vcs_1, respectively, a drain-source voltage of the second switching element at the end of the second mode is Vqs_2, and a voltage across the first capacitor at the end of the second mode is Vcp_2.

### [Mathematical Expression 1]

$$Vqs\_2 = -Vcp\_2$$
$$= \frac{Cs[Qg - Vcp\_1 \cdot Cp] + Ciss[Vcs\_1 \cdot Cs - Vcp\_1 \cdot Cp]}{(Cp \cdot Cs + Cs \cdot Ciss + Ciss \cdot Cp)} > Vth$$

In this way, two-step turn-off of the first switching element can be achieved. As a result, it is possible to achieve a reduction in gate surge, a reduction in switching noise, and a reduction in reverse conduction loss.

Further, the present invention may further include a second resistor having one end connected between the source terminal as one side and the one end of the second capacitor and the cathode terminal of the first Zener diode together as another side, the second resistor having the other end connected to a third terminal of the controller that is directly connected to the voltage source.

With this configuration, the current can be supplied from the voltage source to the first Zener diode and the second capacitor, so that when the voltage source is present, the Zener potential, that is, the negative bias voltage, can be maintained, and the noise tolerance is improved.

Further, the present invention may further include: a third resistor having one end connected to the other end of the first capacitor, and the other end connected to the other end of the first resistor; and a fourth resistor and a first diode connected in series. The fourth resistor has one end connected to the other end of the first capacitor, the other end connected to an anode terminal of the first diode, and the first diode has a cathode terminal connected to the other end of the first resistor.

In this way, the switching speed of the first switching element can be adjusted with the resistance values of the third resistor and the fourth resistor, thereby enabling a reduction in the gate surge of the first switching element and a reduction in switching noise.

Further, the present invention may further include a Schottky diode having a cathode terminal connected to the one end of the first resistor and the one end of the first capacitor, and an anode terminal connected to the other end of the second capacitor and the anode terminal of the first Zener diode.

In this way, the Schottky diode can reduce the gate surge of the first switching element.

Further, the present invention may further include a second Zener diode having a cathode terminal connected to the one end of the first resistor and the one end of the first capacitor, and an anode terminal connected to the one end of the second capacitor and the cathode terminal of the first Zener diode.

With this configuration, the second Zener diode can reduce the gate surge of the first switching element.

Further, the present invention may further include: a plurality of switching elements connected in series; and the gate drive circuit as a gate drive circuit that is connected to a gate terminal and a source terminal of each of the switching elements and turns on and off the switching element.

With this configuration, in the switching element constituting the switching circuit, it is possible to reduce the gate surge and reduce the reverse conduction loss. This makes it possible to prevent malfunction of the switching circuit, reduce occurrence of noise, and enhance efficiency.

EFFECT OF THE INVENTION

According to the present invention, in the gate drive circuit of the switching element, it is possible to reduce the gate surge of the switching element and reduce the reverse conduction loss.

BRIEF DESCRIPTION OF THE DRAWINGS

Fig. 1 is a diagram illustrating a circuit configuration of a gate drive circuit according to a first embodiment.
Fig. 2 is a diagram illustrating a circuit configuration of a synchronous rectification-type boost chopper circuit according to the first embodiment.
Fig. 3 is a sequence diagram for the operation of the switching element by the gate drive circuit according to the first embodiment.
Figs. 4A and 4B are an equivalent circuit diagram and an operation sequence diagram for explaining mode 11.
Figs. 5A and 5B are an equivalent circuit diagram and an operation sequence diagram for explaining mode 12.
Figs. 6A and 6B are an equivalent circuit diagram and an operation sequence diagram for explaining mode 13.
Figs. 7A and 7B are an equivalent circuit diagram and an operation sequence diagram for explaining mode 14.
Figs. 8A and 8B are an equivalent circuit diagram and an operation sequence diagram for explaining mode 15.
Fig. 9 is an operation sequence diagram of the synchronous rectification-type boost chopper circuit according to the first embodiment.
Fig. 10 is a diagram illustrating a circuit configuration of a gate drive circuit according to a second embodiment.
Fig. 11 is a sequence diagram for the operation of the switching element by the gate drive circuit according to the second embodiment.
Figs. 12A and 12B are an equivalent circuit diagram and an operation sequence diagram for explaining mode 21.
Figs. 13A and 13B are an equivalent circuit diagram and an operation sequence diagram for explaining mode 22.
Figs. 14A and 14B are an equivalent circuit diagram and an operation sequence diagram for explaining mode 23.
Figs. 15A and 15B are an equivalent circuit diagram and an operation sequence diagram for explaining mode 24.
Figs. 16A and 16B are an equivalent circuit diagram and an operation sequence diagram for explaining mode 25.
Figs. 17A and 17B are an equivalent circuit diagram and an operation sequence diagram for explaining mode 26.
Fig. 18 is an operation sequence diagram of a synchronous rectification-type boost chopper circuit according to a second embodiment.
Fig. 19 is a diagram illustrating a circuit configuration of a gate drive circuit according to a third embodiment.
Fig. 20 is a diagram illustrating a circuit configuration of a gate drive circuit according to a fourth embodiment.
Fig. 21 is a diagram illustrating a circuit configuration of a gate drive circuit according to a fifth embodiment.
Fig. 22 is a diagram illustrating a circuit configuration of a gate drive circuit according to a sixth embodiment.
Fig. 23 is a simulation model circuit diagram of the gate drive circuit according to the first embodiment.
Fig. 24 is a graph illustrating simulation results of the gate drive circuit according to the first embodiment.
Fig. 25 is a simulation model circuit diagram of a gate drive circuit according to the second embodiment.
Fig. 26 is a graph illustrating simulation results of the gate drive circuit according to the second embodiment.
Fig. 27 is a diagram illustrating a schematic configuration of a switching circuit according to a modification.

MODE FOR CARRYING OUT THE INVENTION

[Application Example]

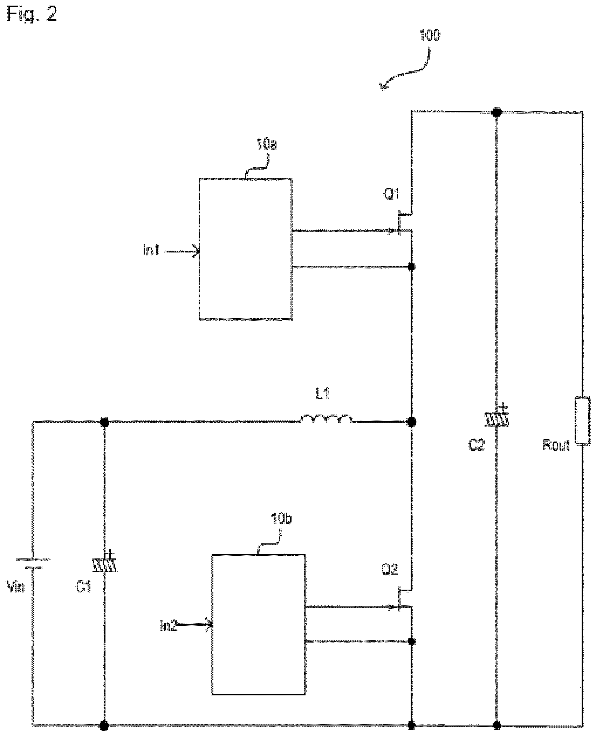

Application examples of the present invention will be described below with reference to the drawings. A gate drive circuit 10 to which the present invention is applied can be used for, for example, gate drive circuits 10a and 10b of a synchronous rectification-type boost chopper circuit 100 illustrated in Fig. 2.

The synchronous rectification-type boost chopper circuit 100 includes switching elements Q1 and Q2, the gate drive circuits 10a and 10b, an input power supply Vin, a reactor L1, bypass capacitors C1 and C2, a load Rout, and the like. In the synchronous rectification-type boost chopper circuit 100, the two switching elements Q1 and Q2 are connected in series, and the gate drive circuits 10a and 10b are connected to the switching elements Q1 and Q2, respectively. The gate drive circuits 10a and 10b boost an input voltage Vin to a desired voltage by switching the switching elements Q1 and Q2 in accordance with input control signals In1 and In2, respectively, and apply the boosted voltage to the load Rout.

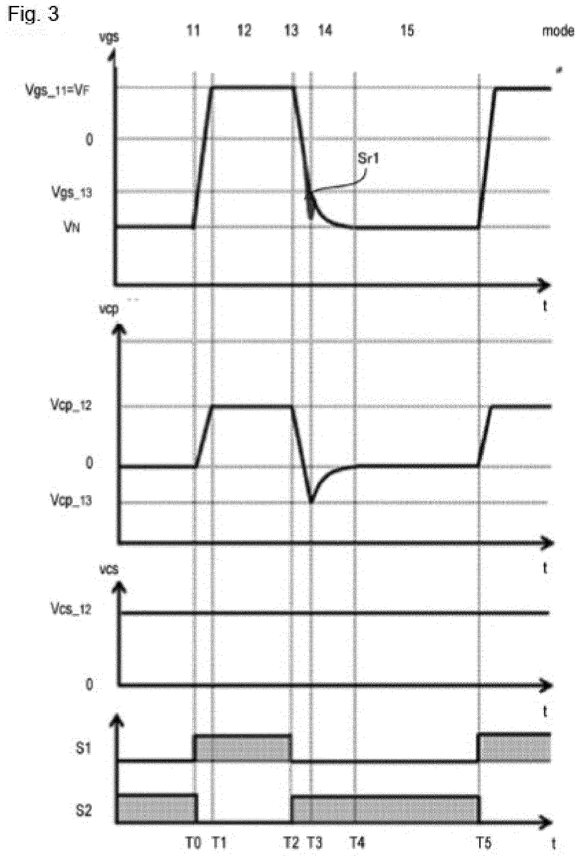

Fig. 3 is an operation sequence diagram of the gate drive circuit 10. By switching switches S1 and S2 of the controller on and off as illustrated in the lower row, a gate-source voltage vgs of the switching element Q1 changes as illustrated in the graph at the top. At this time, the gate-source voltage vgs undergoes a sequential transition through the states of mode 11 to mode 15.

As illustrated in Fig. 3, in mode 13 to which the switching element Q1 transitions from mode 12 where the switching element Q1 was turned on, and in which the switching element Q1 is turned off, the gate-source voltage vgs can be held high, and a surge voltage Sr1 is reduced. It is thus possible to inhibit the breakdown of the switching element Q1 and reduce a reverse conduction loss. In subsequent mode 14, the gate-source voltage is held low when switching noise occurs, thereby enabling the inhibition of erroneous activation.

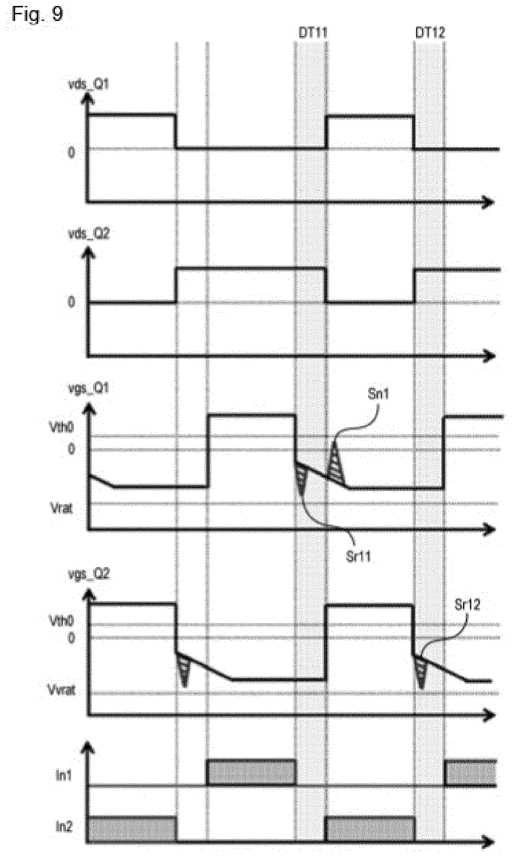

Fig. 9 illustrates an operation sequence diagram in a case where the gate drive circuit 10 according to the present invention is used for a switching circuit such as the synchronous rectification-type boost chopper circuit 100. By holding gate-source voltages vgs_Q1 and vgs_Q2 at high levels when the gates of the switching elements Q1 and Q2 are off, during dead times DT11 and DT12 when both the switching elements Q1 and Q2 are off, gate surges Sr11, Sr12 are reduced to an absolute maximum rating Vrat or higher. It is thus possible to inhibit the breakdown of the switching elements Q1 and Q2 and reduce the reverse conduction loss. In addition, the gate-source voltage vgs_Q1 is held low, at a value equal to or lower than the threshold voltage Vth0 when the switching noise Sn1 occurs, thereby enabling the inhibition of erroneous activation. Similarly, erroneous activation can be inhibited for the switching element Q2. Such a switching circuit may be a half-bridge circuit or a full-bridge circuit as long as the switching circuit performs switching by connecting a plurality of switching elements in series. The switching circuit includes, but is not limited to, a DC to DC converter, an inverter, and the like.

[First Embodiment]

A gate drive circuit 10 according to an embodiment of the present invention will be described in more detail below with reference to the drawings.

<Device configuration>

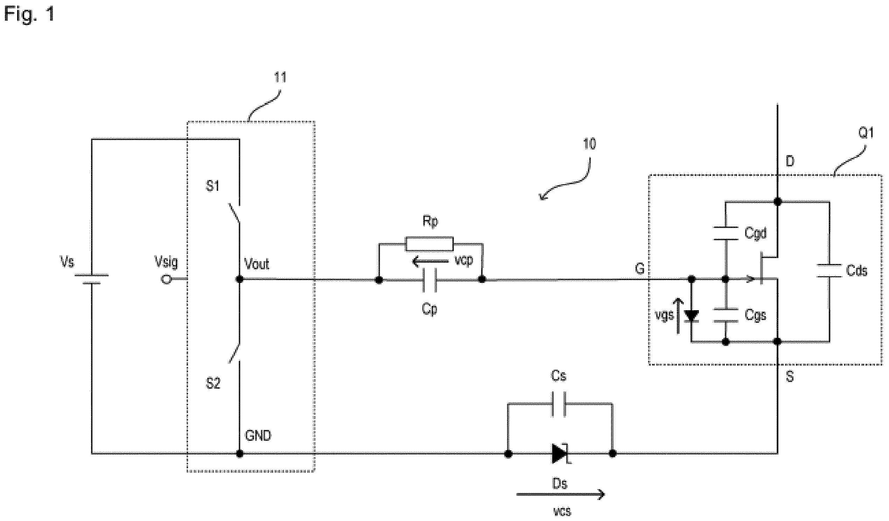

Fig. 1 illustrates the gate drive circuit 10 according to the embodiment. Fig. 2 illustrates a synchronous rectification-type boost chopper circuit 100 to which the gate drive circuit 10 is applied.

First, the synchronous rectification-type boost chopper circuit 100 will be described.

The synchronous rectification-type boost chopper circuit 100 includes switching elements Q1 and Q2, gate drive circuits 10a and 10b, an input power supply Vin, a reactor L1, bypass capacitors C1 and C2, a load Rout, and the like. In the synchronous rectification-type boost chopper circuit 100, the two switching elements Q1 and Q2 are connected in series, and the gate drive circuits 10a and 10b are connected to the switching elements Q1 and Q2, respectively. The gate drive circuits 10a and 10b boost an input voltage Vin to a desired voltage by switching the switching elements Q1 and Q2 in accordance with input control signals In1 and In2, respectively, and apply the boosted voltage to the load Rout. The gate drive circuit 10 applied to the gate drive circuit 10a of the synchronous rectification-type boost chopper circuit 100 will be described below. However, the gate drive circuit 10 can be similarly applied to the gate drive circuit 10b.

Next, the gate drive circuit 10 will be described.

One end of a capacitor Cp, which functions as a speed-up capacitor, is connected to a gate terminal G of the switching element Q1. A resistor Rp, which functions as a limiting resistor for allowing a small current to flow when the switching element Q1 is turned on, is connected in parallel to the capacitor Cp. The other end of the capacitor Cp is connected to an output terminal Vout of a gate driver 11. A source terminal S of the switching element Q1 is connected to a reference potential terminal GND of the gate driver 11 via a capacitor Cs and a Zener diode Ds connected in parallel. That is, the capacitor Cs has one end connected to the source terminal S of the switching element Q1, and the other end connected to the reference potential terminal GND of the gate driver 11. The Zener diode Ds has a cathode terminal connected to the source terminal S of the switching element Q1, and an anode terminal connected to the reference potential terminal GND of the gate driver 11. The gate driver 11 includes two switches S1 and S2 connected in series between a positive terminal and a negative terminal of a voltage source Vs. Switches S1 and S2 are made up of, for example, an n-channel metal-oxide-semiconductor field-effect transistor (MOSFET) and a p-channel MOSFET. The midpoint between switches S1 and S2 is connected to the other end of the capacitor Cp, serving as the output terminal Vout. The gate driver 11 switches switches S1 and S2 on and off based on an input signal Vsig. By turning on switch S1 and turning off switch S2, the other end of the capacitor Cp is connected to the positive terminal of the voltage source Vs via the output terminal Vout, and a gate current flows through the switching element Q1 via the capacitor Cp and the resistor Rp. Then, by turning off switch S1 and turning on switch S2, the other end of the capacitor Cp is connected to the reference potential terminal GND and the other end of the capacitor Cs via the output terminal Vout, and a negative bias voltage is applied between the gate and the source of the switching element Q1. Here, the switching element Q1 corresponds to the first switching element of the present invention, the capacitor Cp corresponds to the first capacitor of the present invention, the resistor Rp corresponds to the first resistor of the present invention, the capacitor Cs corresponds to the second capacitor of the present invention, the Zener diode Ds corresponds to the first Zener diode of the present invention, the gate driver 11 corresponds to the controller of the present invention, the output terminal Vout corresponds to the first terminal of the present invention, the reference potential terminal GND corresponds to the second terminal of the present invention, switch S1 corresponds to the first switch of the present invention, and switch S2 corresponds to the second switch of the present invention.

The switching element Q1 (Q2 as well) includes, but is not limited to, a JFET, for example. Fig. 1 illustrates the switching element Q1 including a drain-source capacitance Cds, a gate-drain capacitance Cgd, and a gate-source capacitance Cgs, which are capacitances between the electrodes. An input capacitance Ciss of the switching element Q1 is expressed by the sum of Cgs and Cgd.

The operation principle of the gate drive circuit 10 according to the embodiment will be described. Fig. 3 is an operation sequence diagram illustrating changes in the gate-source voltage vgs, the voltage vcp of the capacitor Cp, and the voltage vcs of the capacitor Cs when switches S1 and S2 of the gate driver 11 of the gate drive circuit 10 are turned on and off. The gate drive circuit 10 sequentially transitions through five modes: mode 11, mode 12, mode 13, mode 14, and mode 15. This sequence lasts until switch S1 is turned on and then off, switch S2 is subsequently turned on and then off, and switch S1 is turned on again. The gate-source voltage vgs of the switching element Q1 changes as illustrated in Fig. 3 according to the transition from mode 11 to mode 15.

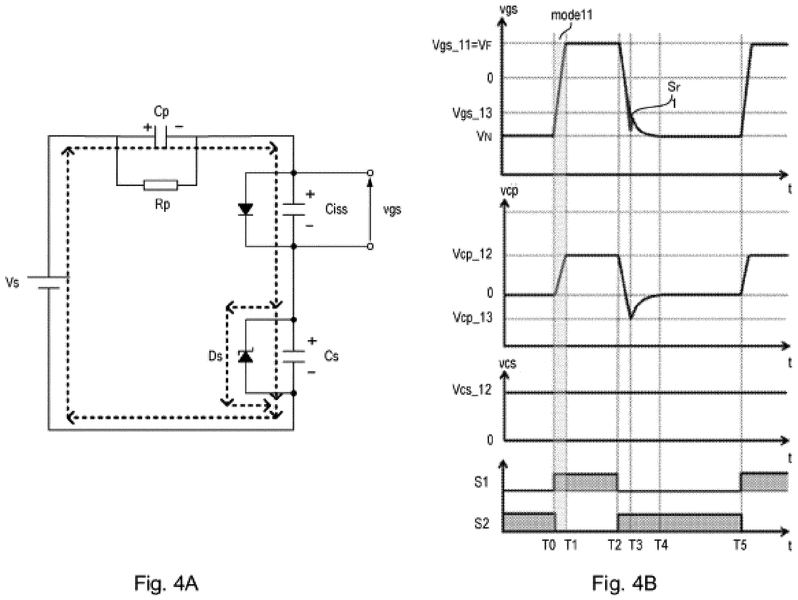

Fig. 4A is an equivalent circuit of the gate drive circuit 10 in mode 11 where switch S1 has been turned on, and Fig. 4B is an operation sequence diagram with mode 11 indicated by shading. In the equivalent circuit, the dashed arrows indicate the current path and the current direction (this also applies to the equivalent circuit described below). At this time, the input capacitance Ciss of the switching element Q1 is charged through the capacitor Cp, the capacitor Cs, and the Zener diode Ds, and as illustrated in Fig. 4B, the gate-source voltage vgs increases, and the switching element Q1 transitions to the turn-on state.

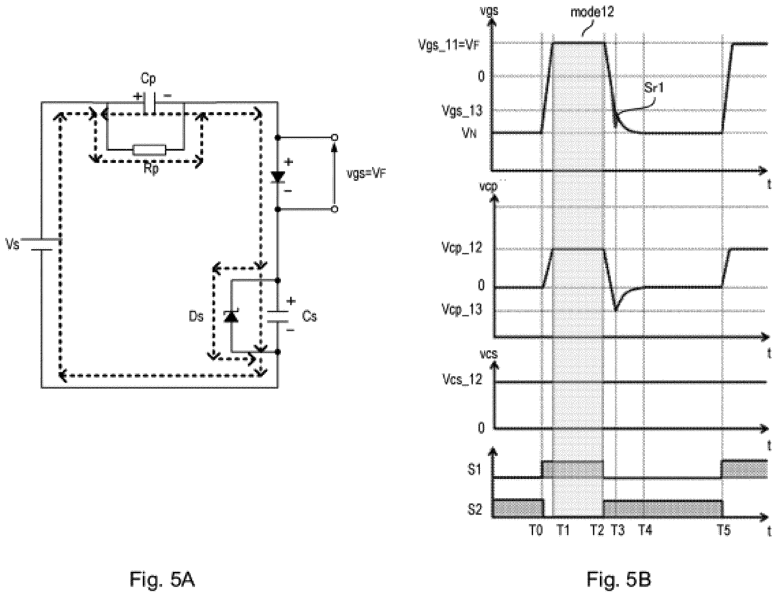

Fig. 5A is an equivalent circuit of the gate drive circuit 10 in mode 12, and Fig. 5B is an operation sequence diagram with mode 12 indicated by shading. This is a period in which the input capacitance Ciss of the switching element Q1 is charged and the turn-on state continues. At this time, as illustrated in Fig. 5B, the gate-source voltage vgs of the switching element Q1 is clamped to a constant voltage $V_F$ by the parasitic diode of the switching element Q1.

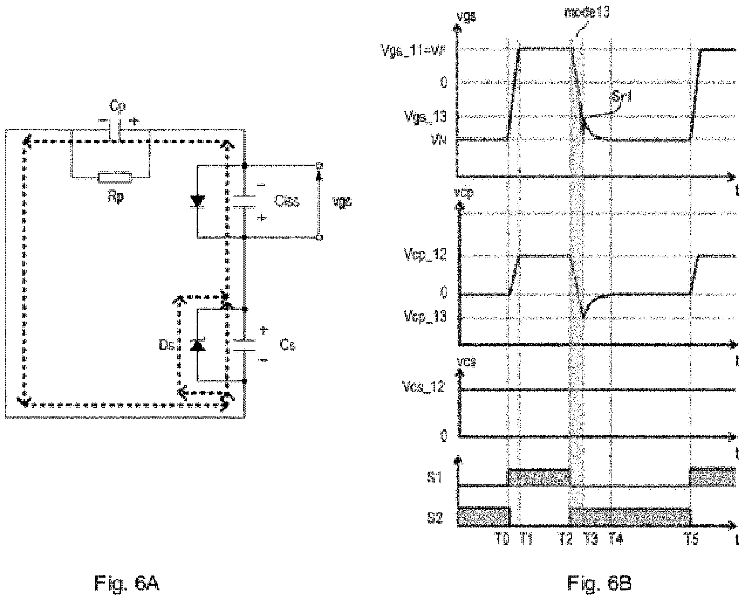

Fig. 6A is an equivalent circuit of the gate drive circuit 10 in mode 13 where switch S2 has been turned on, and Fig. 6B is an operation sequence diagram with mode 13 indicated by shading. At this time, the input capacitance Ciss of the switching element Q1 is discharged through the capacitor Cp, the capacitor Cs, and the Zener diode Ds, and the switching element Q1 transitions to the turn-off state. As illustrated in Fig. 6B, in mode 13, the gate-source voltage vgs is turned off at a high voltage, and hence the gate surge Sr1 is reduced.

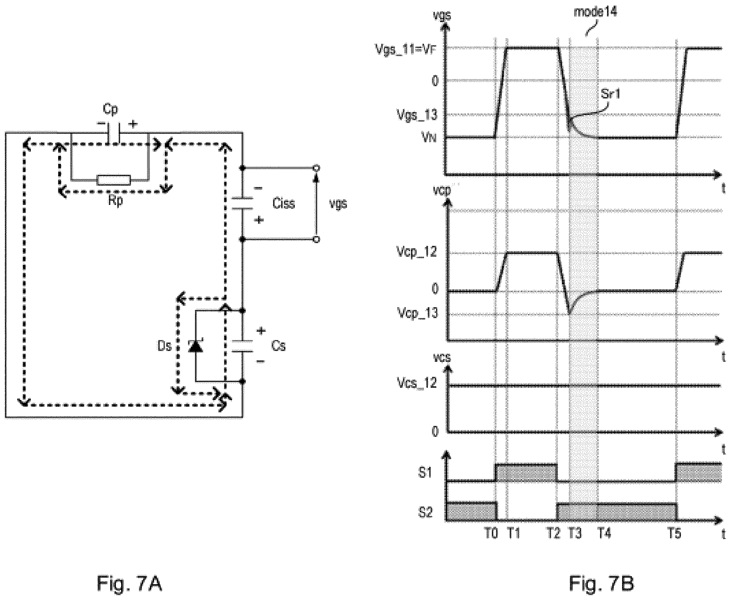

Fig. 7A is an equivalent circuit of the gate drive circuit 10 in mode 14, and Fig. 7B is an operation sequence diagram with mode 14 indicated by shading. At this time, the input capacitance Ciss, the capacitor Cp, and the capacitor Cs of the switching element Q1 are charged and discharged through the Zener diode Ds. As illustrated in Fig. 7B, the gate-source voltage vgs of the switching element Q1 is held high, thus reducing the reverse conduction loss.

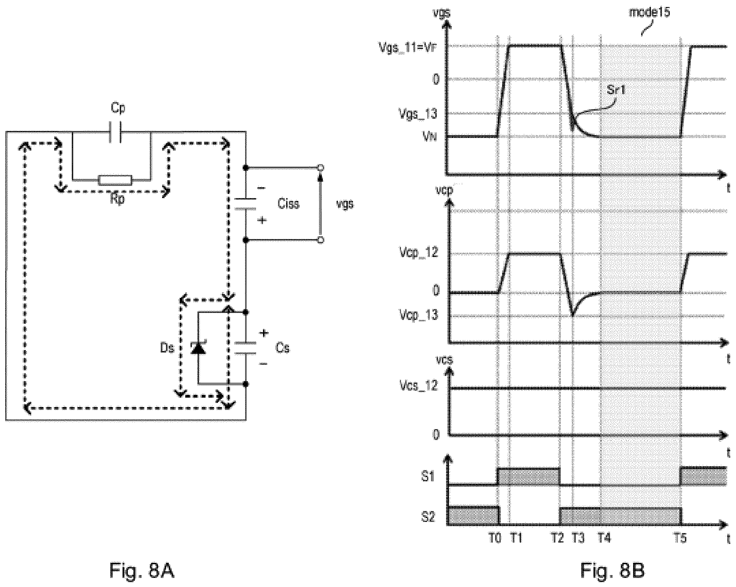

Fig. 8A is an equivalent circuit of the gate drive circuit 10 in mode 15, and Fig. 8B is an operation sequence diagram with mode 15 indicated by shading. At this time, the input capacitance Ciss and the capacitor Cs of the switching element Q1 are discharged through the resistor Rp and the Zener diode Ds. By increasing the capacitance of the capacitor Cs, the gate-source voltage vgs of the switching element Q1 is held at a Zener potential VN of the Zener diode Ds as illustrated in Fig. 8B.

Fig. 9 illustrates an operation sequence diagram of the synchronous rectification-type boost chopper circuit 100 in which the gate drive circuit 10 described above is applied to the gate drive circuits 10a and 10b. In Fig. 9, vds_Q1 and vds_Q2 represent the drain-source voltages of the switching element Q1 and the switching element Q2, respectively, and vgs_Q1 and vgs_Q2 represent the gate-source voltages of the switching element Q1 and the switching element Q2, respectively. In1 and In2 are input signals to the gate drive circuits 10a and 10b.

As illustrated in Fig. 9, by using the gate drive circuit 10 and holding the gate-source voltages vgs_Q1 and vgs_Q2 at high levels when the gates of the switching elements Q1 and Q2 are off, during dead times DT11 and DT12 when both the switching elements Q1 and Q2 are off, the gate surges Sr11, Sr12 are reduced to an absolute maximum rating Vrat or higher. It is thus possible to inhibit the breakdown of the switching elements Q1 and Q2 and reduce the reverse conduction loss. In addition, the gate-source voltage vgs_Q1 is held low, at a value equal to or lower than the threshold voltage Vth0 when the switching noise Sn1 occurs, thereby enabling the inhibition of erroneous activation. Similarly, erroneous activation can be inhibited for the switching element Q2.

In this way, the gate surge can be reduced in the switching element constituting the synchronous rectification-type boost chopper circuit 100. As a result, it is possible to prevent a malfunction of the synchronous rectification-type boost chopper circuit 100 and to achieve the synchronous rectification-type boost chopper circuit 100 with high reliability.

[Second Embodiment]

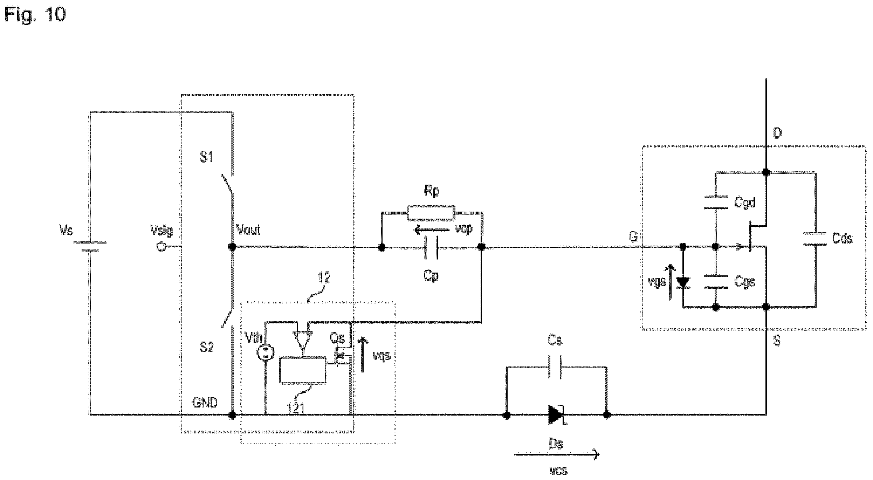

A gate drive circuit 20 according to a second embodiment of the present invention will be described below with reference to Fig. 10.

The same components as those in the first embodiment are denoted by the same reference numerals, and detailed description thereof is omitted.

In the embodiment, a mirror clamp circuit 12 is provided in the gate drive circuit 10 according to the first embodiment. The mirror clamp circuit 12 includes a switching element Qs and a clamp logic circuit 121. The switching element Qs is connected between the gate terminal G of the switching element Q1 as one side and one end of the capacitor Cp and one end of the resistor Rp together as another side, and between the other end of the capacitor Cs and the anode terminal of the Zener diode Ds. Here, an n-channel MOSFET is used as the switching element Qs. The drain terminal of the switching element Qs is connected to the gate terminal G side of the switching element Q1. The source terminal of the switching element Qs is connected to the other end of the capacitor Cs and the anode terminal side of the Zener diode Ds. Further, the gate terminal of the switching element Qs is connected to the clamp logic circuit 121. The clamp logic circuit 121 operates to bring the switching element Qs into a conductive state when the drain voltage of the switching element Qs becomes equal to or lower than Vth. At this time, the switching element Q1 is turned off in two steps by satisfying the following mathematical expression. Here, Vqs_23 and Vcp_23 are the drain-source voltage vqs of the switching element Qs and the voltage vcp of the capacitor Cp at the end of mode 23, respectively. Vcp_22 and Vcs_22 are the voltage vcp across the capacitor Cp and the voltage vcs across the capacitor Cs at the end of mode 22. Cp and Cs represent the capacitances of the capacitors Cp, Cs. Qg and Ciss are the gate charge amount and the input capacitance of the switching element Q1. Vth is a threshold voltage at which the switching element Qs of the mirror clamp circuit 12 is turned on.

[Mathematical Expression 2]

$$Vqs\_23 = -Vcp\_23$$
$$= \frac{Cs[Qg - Vcp\_22 \cdot Cp] + Ciss[Vcs\_22 \cdot Cs - Vcp\_22 \cdot Cp]}{(Cp \cdot Cs + Cs \cdot Ciss + Ciss \cdot Cp)} > Vth$$

Here, the switching element Qs corresponds to the second switching element of the present invention. Mode 22 and mode 23 correspond to the first mode and the second mode of the present invention, and mode 21 to mode 26 correspond to a plurality of modes of the present invention. Vqs_23 and Vcp_23 correspond to Vqs_2 and Vcp_2 of the present invention, respectively. Vcp_22 and Vcs_22 correspond to Vcp_1 and Vcs_1 of the present invention, respectively. Ciss, Cp and Cs correspond to Ciss, Cp and Cs of the present invention, respectively. Qg corresponds to Qg of the present invention.

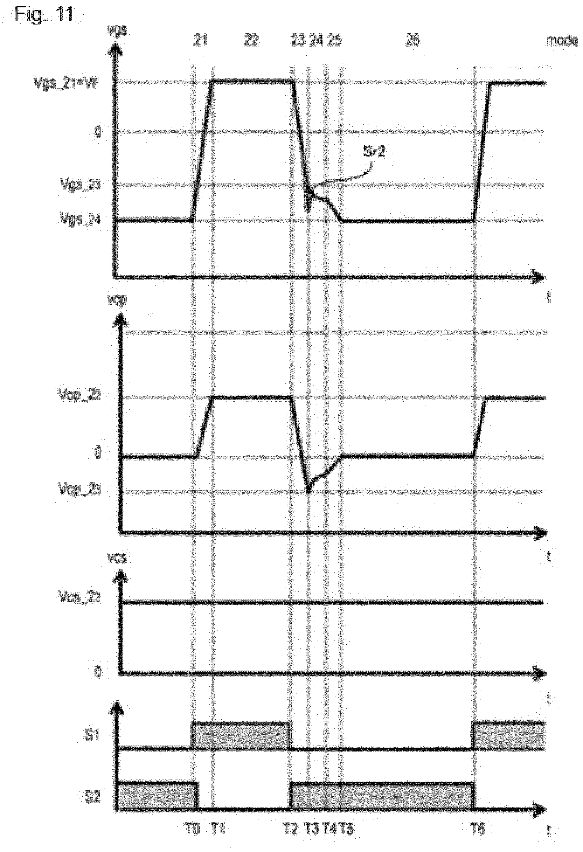

The operation principle of the gate drive circuit 20 according to the embodiment will be described. Fig. 11 is an operation sequence diagram illustrating changes in the gate-source voltage vgs, the voltage vcp of the capacitor Cp, and the voltage vcs of the capacitor Cs when switches S1 and S2 of the gate driver 11 of the gate drive circuit 20 are turned on and off. The gate drive circuit 10 sequentially transitions through six modes: mode 21, mode 22, mode 23, mode 24, mode 25, and mode 26. This sequence lasts until switch S1 is turned on and then off, switch S2 is subsequently turned on and then off, and switch S1 is turned on again. The gate-source voltage vgs of the switching element Q1 changes as illustrated in Fig. 11 according to the transition from mode 21 to mode 26.

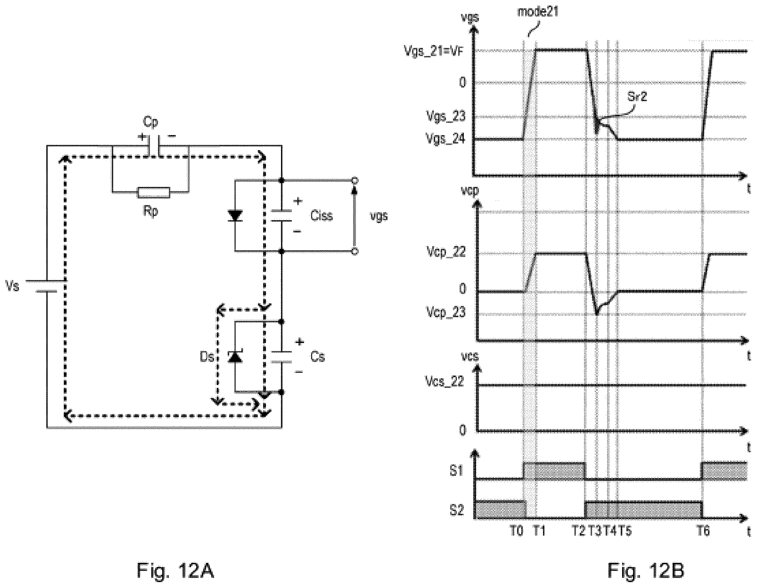

Fig. 12A is an equivalent circuit of the gate drive circuit 20 in mode 21 where switch S1 has been turned on, and Fig. 12B is an operation sequence diagram with mode 21 indicated by shading. At this time, the input capacitance Ciss of the switching element Q1 is charged through the capacitor Cp, the capacitor Cs, and the Zener diode Ds, and as illustrated in Fig. 12B, the gate-source voltage vgs increases, and the switching element Q1 transitions to the turn-on state.

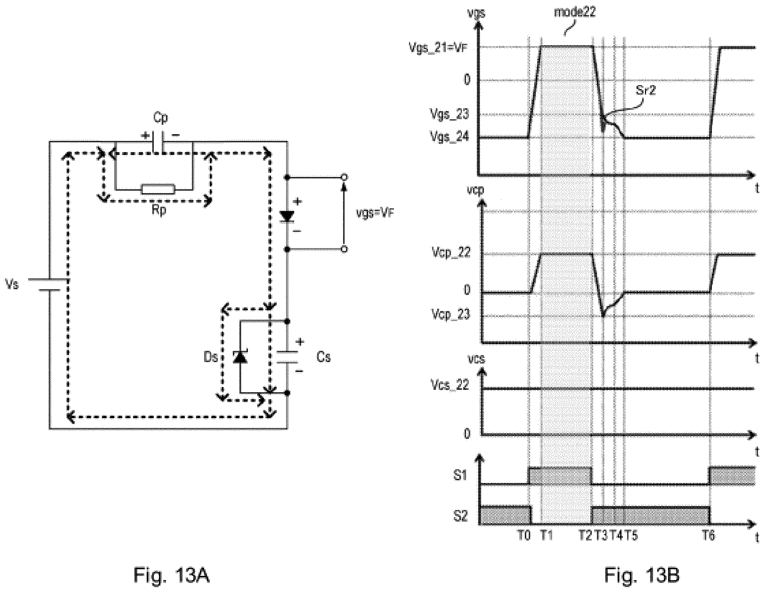

Fig. 13A is an equivalent circuit of the gate drive circuit 20 in mode 22, and Fig. 13B is an operation sequence diagram with mode 22 indicated by shading. This is a period in which the input capacitance Ciss of the switching element Q1 is charged and the turn-on state continues. At this time, as illustrated in Fig. 13B, the gate-source voltage vgs of the switching element Q1 is clamped to a constant voltage $V_F$ by the parasitic diode of the switching element Q1.

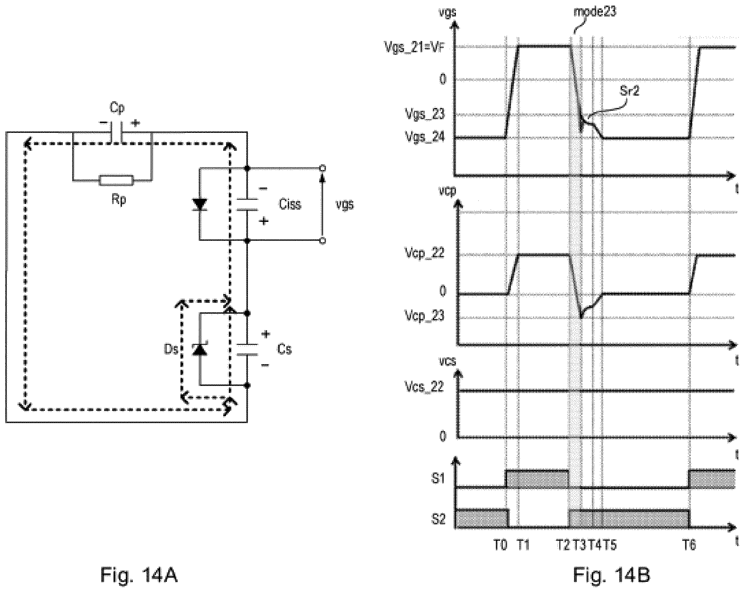

Fig. 14A is an equivalent circuit of the gate drive circuit 20 in mode 23 where switch S2 has been turned on, and Fig. 14B is an operation sequence diagram with mode 23 indicated by shading. At this time, the input capacitance Ciss of the switching element Q1 is discharged through the capacitor Cp, the capacitor Cs, and the Zener diode Ds, and the switching element Q1 transitions to the turn-off state. As illustrated in Fig. 14B, in this mode 23, the gate-source voltage vgs is turned off at a high voltage, and hence a gate surge Sr2 is reduced.

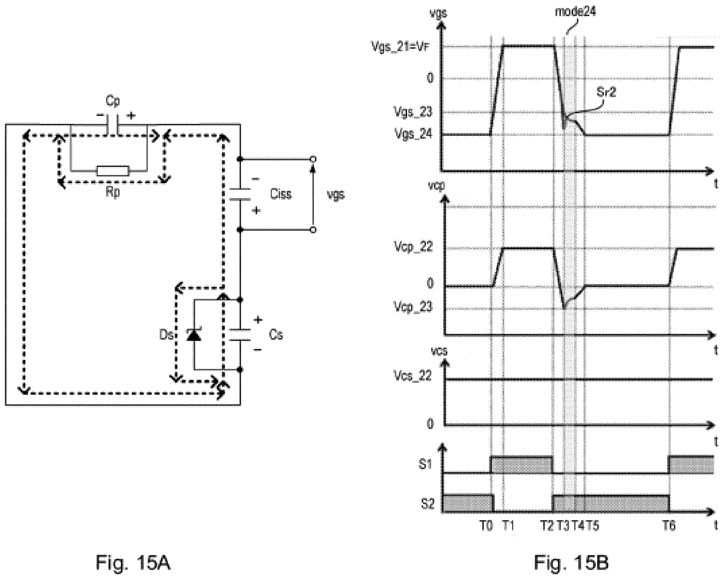

Fig. 15A is an equivalent circuit of the gate drive circuit 20 in mode 24, and Fig. 15B is an operation sequence diagram with mode 24 indicated by shading. At this time, the input capacitance Ciss, the capacitor Cp, and the capacitor Cs of the switching element Q1 are charged and discharged through the Zener diode Ds and the resistor Rp. As illustrated in Fig. 15B, the gate-source voltage vgs of the switching element Q1 is held high, thus reducing the reverse conduction loss.

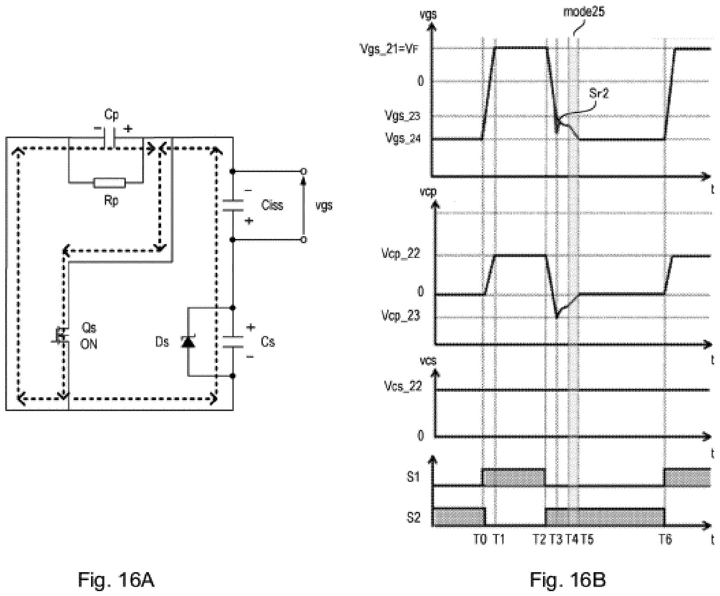

Fig. 16A is an equivalent circuit of the gate drive circuit 20 in mode 25, and Fig. 16B is an operation sequence diagram with mode 25 indicated by shading. When the drain-source voltage of the switching element Qs becomes equal to or lower than vth, the switching element Qs shifts to a conductive state. As a result, two-step turn-off of the switching element Q1 is achieved. Increasing the negative bias value in this manner can prevent malfunction due to switching noise during the switching of the switching element (the switching element Q2 in Fig. 2) in the opposing arm.

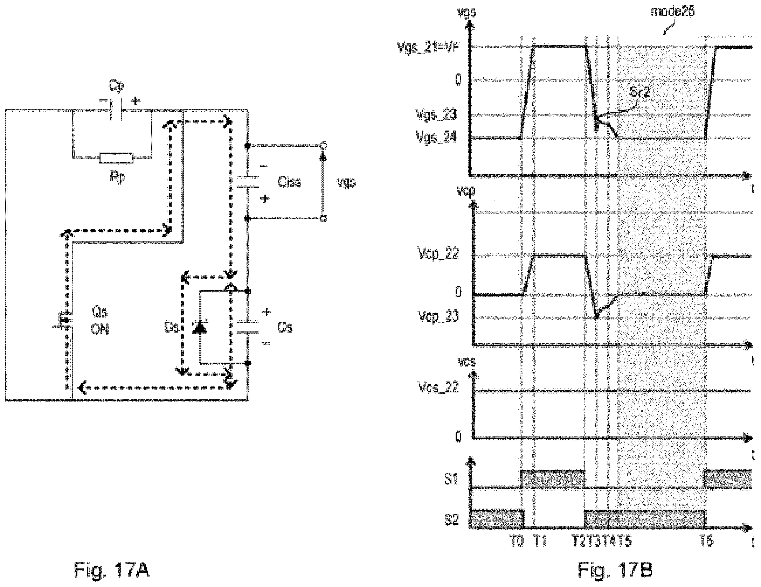

Fig. 17A is an equivalent circuit of the gate drive circuit 20 in mode 26, and Fig. 17B is an operation sequence diagram with mode 26 indicated by shading. At this time, the input capacitance Ciss and the capacitor Cs of the switching element Q1 are discharged through the switching element Qs and the Zener diode Ds. By increasing the capacitance of the capacitor Cs, the gate-source voltage vgs of the switching element Q1 can be held at the Zener potential of the Zener diode Ds.

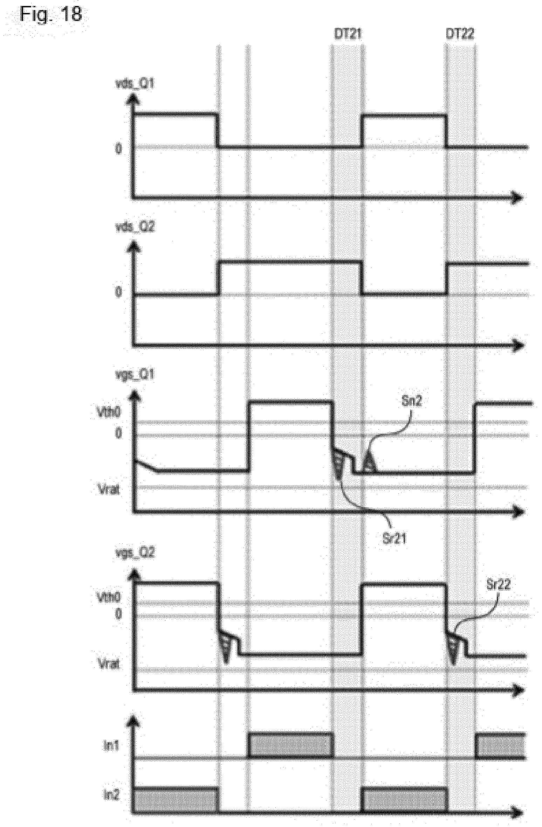

Fig. 18 illustrates an operation sequence diagram of the synchronous rectification-type boost chopper circuit 100 in which the gate drive circuit 20 described above is applied to the gate drive circuits 10a and 10b. In Fig. 18, vds_Q1 and vds_Q2 represent the drain-source voltages of the switching element Q1 and the switching element Q2, respectively, and vgs_Q1 and vgs_Q2 represent the gate-source voltages of the switching element Q1 and the switching element Q2, respectively. In1 and In2 are input signals to the gate drive circuits 10a and 10b.

As illustrated in Fig. 18, by adding the mirror clamp circuit 12, in the gate drive circuit 20, the switching element Qs enters a conductive state when the drain voltage of the switching element Qs becomes equal to or lower than Vth. This makes it possible to turn off the gate-source voltage vgs of the switching element Q1 in two steps. By achieving the first-step turn-off of the switching element Q1 with a high voltage, a gate surge Sr21 is reduced at dead time DT21 when both the switching elements Q1 and Q2 are off, and the gate surge is set to Vrat or more (Sr22 at dead time DT22 as well). It is thus possible to inhibit the breakdown of the switching element Q1 (the switching element Q2 as well) and reduce the reverse conduction loss. Then, the switching element Qs of the mirror clamp circuit 12 is brought into a conductive state before the switching element (the switching element Q2 in Fig. 2) in the opposing arm is switched, so that the gate-source voltage vgs of the switching element Q1 can be lowered during the switching of the switching element of the opposing arm. As a result, malfunction can be inhibited. In addition, by reducing the impedance of the switching noise current through the switching element Qs, the switching noise of the switching element Q1 can be reduced and malfunction can be inhibited.

[Third embodiment]

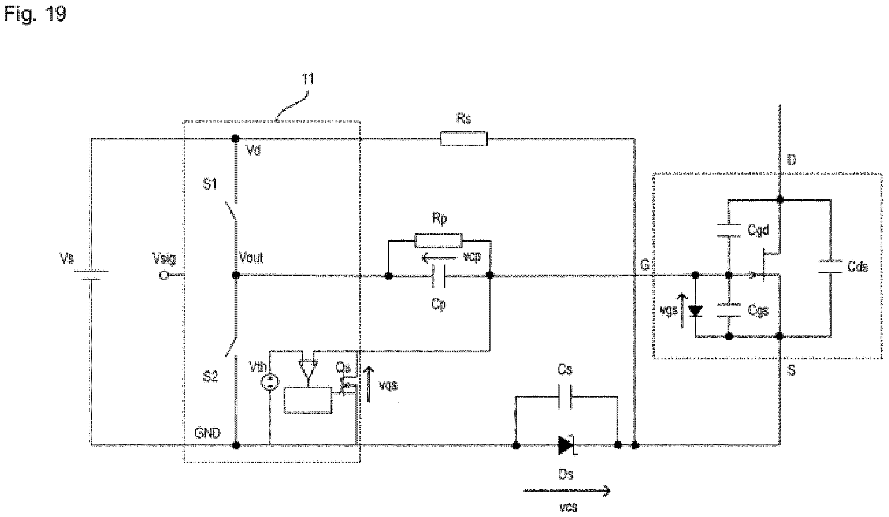

A gate drive circuit 30 according to a third embodiment of the present invention will be described below with reference to Fig. 19.

The same components as those in the first and second embodiments are denoted by the same reference numerals, and detailed description thereof is omitted. In the embodiment, a resistor Rs is added to the gate drive circuit 20 according to the second embodiment. One end of the resistor Rs is connected between the source terminal S of the switching element Q1 as one side and one end of the capacitor Cs and the cathode terminal of the Zener diode Ds together as another side. The other end of the resistor Rs is connected to a Vd terminal between the positive terminal of the voltage source Vs and the switch S1 of the gate driver 11. That is, the other end of the resistor Rs is directly connected to the positive terminal of the voltage source Vs, and is connected to the output terminal Vout of the gate driver 11 via switch S1.

Here, the resistor Rs corresponds to the second resistor of the present invention, and the Vd terminal corresponds to the third terminal of the present invention.

In the gate drive circuit 30, a current can be supplied to the Zener diode Ds and the capacitor Cs via the voltage source Vs. Therefore, the voltage source Vs can maintain the Zener potential (negative bias voltage) in any case.

[Fourth Embodiment]

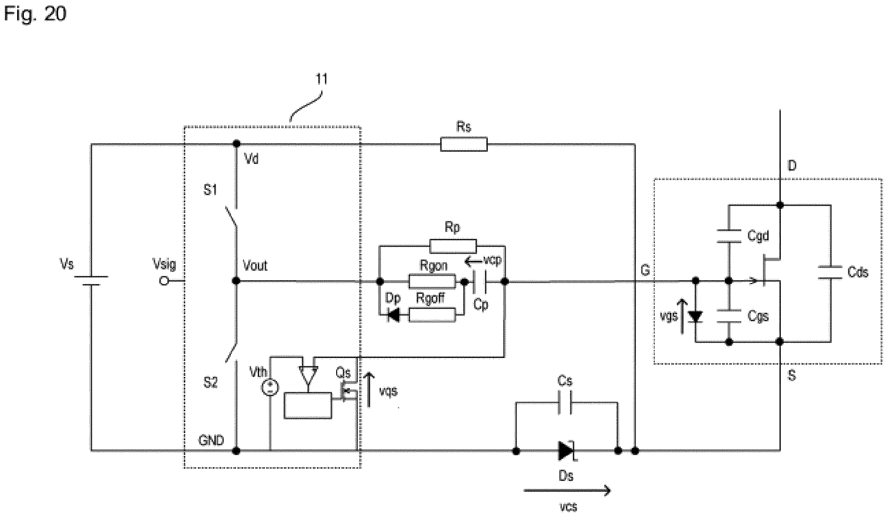

A gate drive circuit 40 according to a fourth embodiment of the present invention will be described below with reference to Fig. 20.

The same components as those in the first to third embodiments are denoted by the same reference numerals, and detailed description thereof is omitted. In the embodiment, a resistor Rgon, a resistor Rgoff, and a diode Dp are added to the gate drive circuit 30 according to the third embodiment.

One end of the resistor Rgon is connected to the other end of the capacitor Cp. The other end of the resistor Rgon is connected to the output terminal Vout side of the gate driver 11 and the other end side of the resistor Rp. Therefore, the resistor Rgon is connected in series with the capacitor Cp, and the resistor Rgon and the capacitor Cp are connected in parallel to the resistor Rp. In addition, the resistor Rgoff and the diode Dp connected in series are connected in parallel to the resistor Rgon. One end of the resistor Rgoff is connected to one end of the resistor Rgon, that is, the other end side of the capacitor Cp. The other end of the resistor Rgoff is connected to the anode terminal side of the diode Dp. The cathode terminal of the diode Dp is connected to the other end side of the resistor Rgon, that is, the other end side of the resistor Rp and the output terminal Vout side of the gate driver 11.

Here, the resistor Rgon, the resistor Rgoff, and the diode Dp correspond to the third resistor, the fourth resistor, and the first diode of the present invention, respectively.

In the gate drive circuit 40, the turn-on and turn-off switching speeds of the switching element Q1 can be changed by changing the resistance values of the resistor Rgon and the resistor Rgoff, respectively

In the embodiment, changing the switching speed enables a reduction in erroneous activation and the prevention of the gate surge.

[Fourth Embodiment]

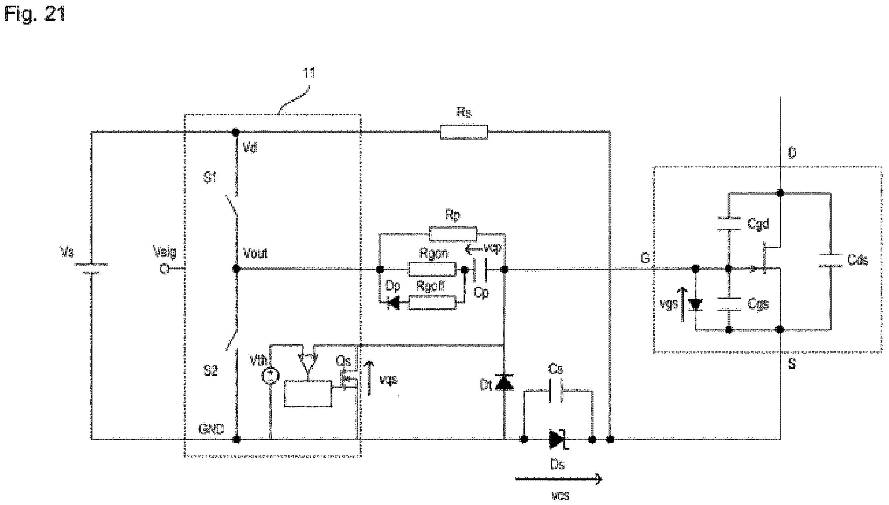

A gate drive circuit 50 according to a fifth embodiment of the present invention will be described below with reference to Fig. 21.

The same components as those in the first to fourth embodiments are denoted by the same reference numerals, and detailed description thereof is omitted. In the embodiment, a Schottky diode Dt is added to the gate drive circuit 40 according to the fourth embodiment.

In the gate drive circuit 50, the cathode terminal of the Schottky diode Dt is connected to the gate terminal G of the switching element Q1, one end side of the resistor Rp and the capacitor Cp, and the drain terminal side of the switching element Qs of the mirror clamp circuit 12. The anode terminal of the diode Dt is connected to the other end of capacitor Cs, the anode terminal side of Zener diode Ds, and the source terminal side of the switching element Qs of mirror clamp circuit 12, that is, the reference potential terminal GND side of the gate driver 11. Here, the Schottky diode Dt corresponds to the Schottky diode of the present invention.

By providing the diode Dt in the gate drive circuit 50, the switching noise of the switching element Q1 can be reduced.

[Fifth Embodiment]

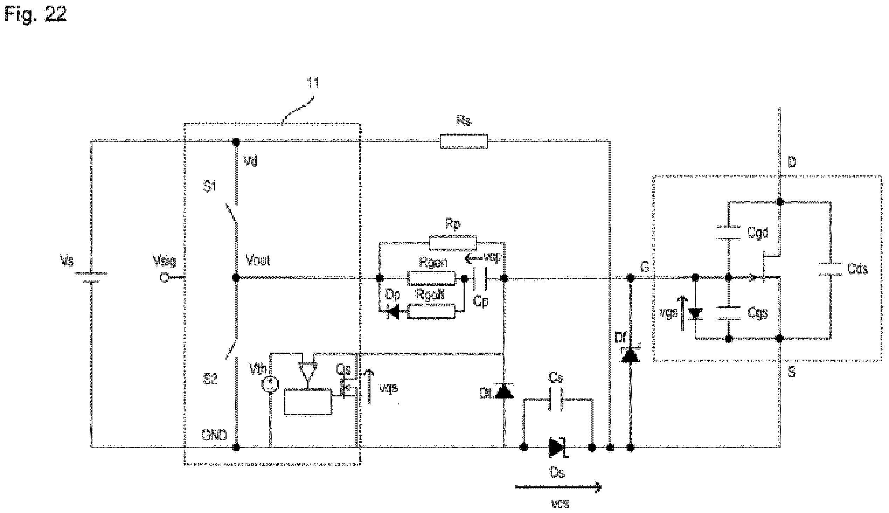

A gate drive circuit 60 according to a sixth embodiment of the present invention will be described below with reference to Fig. 22.

The same components as those in the first to fifth embodiments are denoted by the same reference numerals, and detailed description thereof is omitted. In the embodiment, a Zener diode Df is added to the gate drive circuit 50 according to the fifth embodiment.

In the gate drive circuit 60, the cathode terminal of the Zener diode Df is connected between the gate terminal G of the switching element Q1 as one side and one end of the resistor Rp and one end of the capacitor Cp together as another side. The anode terminal of the Zener diode Df is connected between the source terminal S of the switching element Q1 as one side and one end of the resistor Rs and the capacitor Cs and the cathode terminal of the Zener diode Ds together as another side. Here, the Zener diode Df corresponds to the second Zener diode of the present invention.

In the gate drive circuit 60, by providing the Zener diode Df, the switching noise of the switching element Q1 can be reduced.

(Simulation 1)

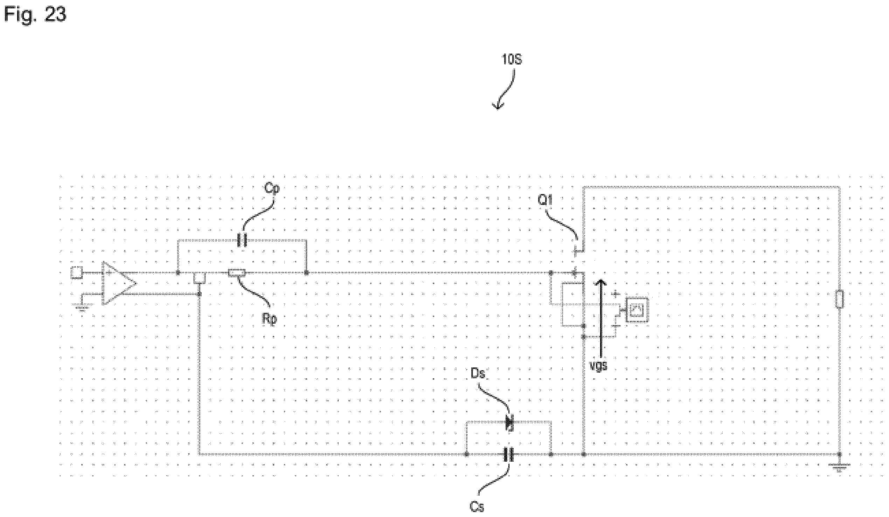

A gate drive circuit 10S illustrated in Fig. 23 was created as model corresponding to the gate drive circuit 10 according to the first embodiment illustrated in Fig. 1, and the effect of negative biasing was confirmed using circuit simulator software.

In the circuit simulator, a simulation was performed with the following settings: the gate power supply at 12 V, the drive frequency at 100 kHz, the duty cycle at 50%, the resistor Rp with a resistance value of 130 $\Omega$, the capacitor Cp with a capacitance of 600 pF, and the capacitor Cs with a capacitance of 10 $\mu$F.

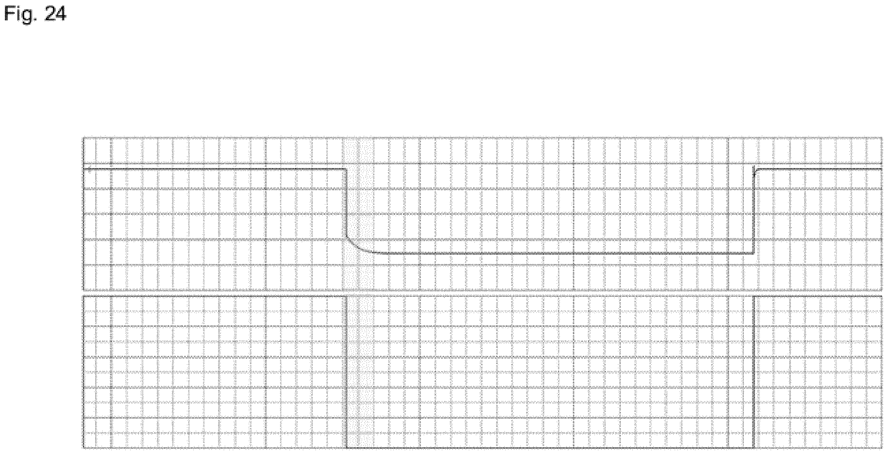

Fig. 24 illustrates simulation results. The upper row shows the gate-source voltage vgs of the switching element Q1, and the lower row shows the input signal In. The turn-off time, when the input signal In is turned off, is indicated by shading in Fig. 23. The simulation results illustrated in Fig. 24 confirm that the gate drive circuit 10 can achieve turn-off when the gate-source voltage vgs is high.

(Simulation 2)

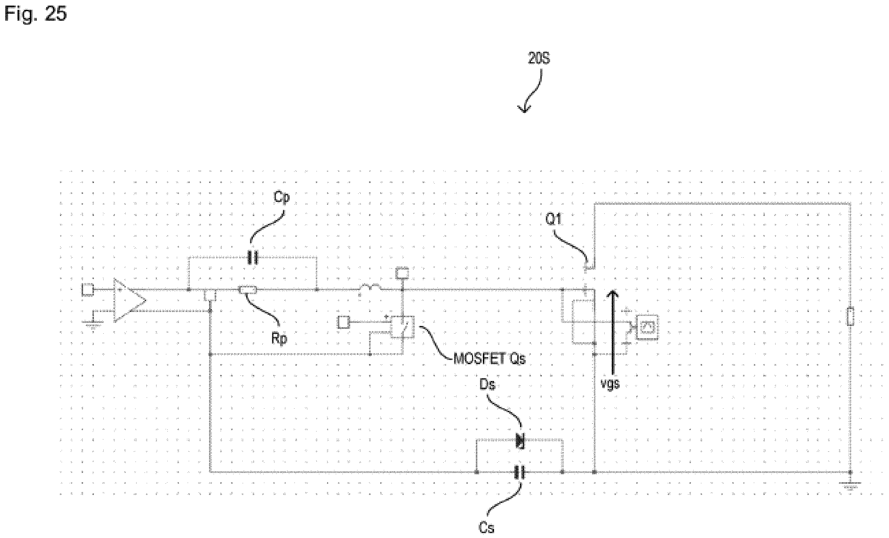

A gate drive circuit 20S illustrated in Fig. 25 was created as model corresponding to the gate drive circuit 20 according to the second embodiment illustrated in Fig. 10, and the effect of negative biasing was confirmed using circuit simulator software.

In the circuit simulator, a simulation was performed with the following settings: the gate power supply at 12 V, the drive frequency at 100 kHz, the duty cycle at 50%, the resistor Rp with a resistance value of 130 Ω, the capacitor Cp with a capacitance of 600 pF, and the capacitor Cs with a capacitance of 10 μF, and the addition of a MOSFET Qs, which functions as the mirror clamp circuit 12.

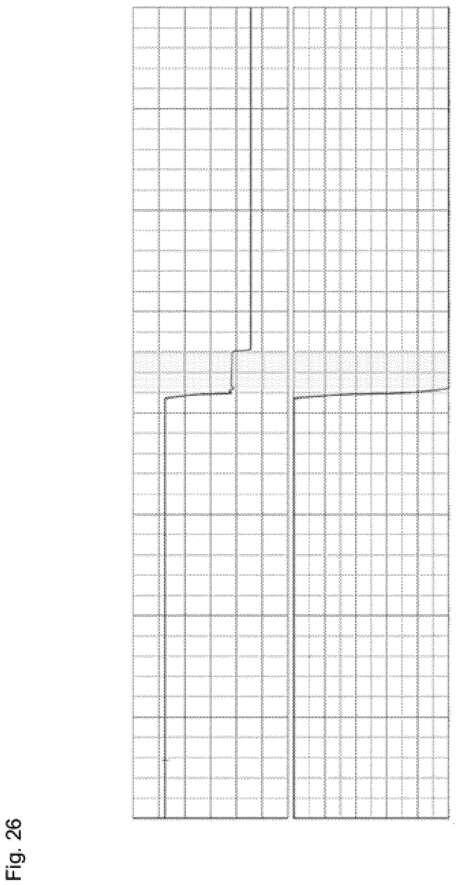

Fig. 26 illustrates simulation results. The upper row shows the gate-source voltage vgs of the switching element Q1, and the lower row shows the input signal In. The turn-off time, when the input signal In is turned off, is indicated by shading in Fig. 23. The simulation results illustrated in Fig. 26 confirm that the gate drive circuit 10 can achieve turn-off when the gate-source voltage vgs is high. As illustrated in Fig. 26, when the MOSFET Qs conducts, the gate-source voltage vgs of the switching element Q1 steeply attenuates. This illustrates that, for example, in the synchronous rectification-type boost chopper circuit 100 using the gate drive circuit 20, by lowering the gate-source voltage vgs of the switching element Q1 during the switching of the switching element (the switching element Q2 in Fig. 2) in the opposing arm, switching noise can be reduced and malfunction can be prevented.

(Modification)

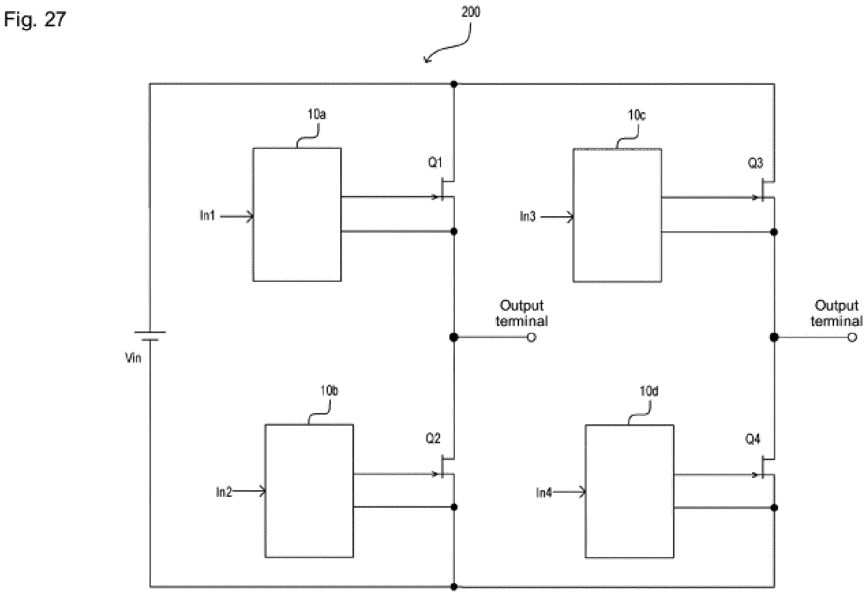

As a switching circuit to which the gate drive circuits 10 to 50 according to the first to fifth embodiments described above can be applied as a gate drive circuit of a switching element, the synchronous rectification-type boost chopper circuit 100, which is a half-bridge circuit with two switching elements connected in series, has been described. However, the switching circuit, to which the gate drive circuits 10 to 50 according to the first to fifth embodiments can be applied as the gate drive circuit of the switching element, is not limited to the above synchronous rectification-type boost chopper circuit 100. For example, as illustrated in Fig. 27, the gate drive circuits 10 to 50 according to the first to fifth embodiments can also be applied as gate drive circuits 10a to 10d of switching elements Q1 to Q4 included in a switching circuit 200 configured as a full-bridge circuit in which two switching elements Q1 and Q2 connected in series and switching elements Q3 and Q4 connected in series are connected in parallel.

Any switching circuit may be used as long as a plurality of switching elements driven by the gate drive circuit according to the embodiment of the present invention are connected in series, and the switching circuit may be a DC to DC converter or an inverter.

<Supplementary note 1>

A gate drive circuit 10 that is connected to a gate terminal (G) and a source terminal (S) of a first switching element (Q1) and turns on and off the first switching element (Q1), the gate drive circuit including:

a controller (11) that includes a first terminal (Vout) connected to the gate terminal (G) and a second terminal (GND) connected to the source terminal (S), includes a first switch (S1) provided between the first terminal (Vout) and a voltage source (Vs), and a second switch (S2) provided between the first terminal (Vout) and the second terminal (GND), and is configured to close the first switch (S1) to supply a current from the first terminal (Vout) to the gate terminal (G); and
a first resistor (Rp) and a first capacitor (Cp), each having one end connected to the gate terminal (G) and the other end connected to the first terminal (Vout), the first resistor (Rp) and the first capacitor (Cp) being connected in parallel to each other;
a second capacitor (Cs) that has one end connected to the source terminal (S) and the other end connected to the second terminal (GND); and
a first Zener diode (Ds) that has a cathode terminal connected to the source terminal (S), an anode terminal connected to the second terminal (GND), and connected in parallel to the second capacitor (Cs).

DESCRIPTION OF SYMBOLS

| 10 | gate drive circuit |
| 11 | gate driver |
| 100 | synchronous rectification-type boost chopper circuit |
| Q1 | switching element |
| S1, S2 | switch |
| Rp | resistor |
| Cp, Cs | capacitor |
| Ds | Zener diode |

**EP 4 366 147 A1**

Claims

1. A gate drive circuit that is connected to a gate terminal and a source terminal of a first switching element and turns on and off the first switching element, the gate drive circuit comprising:

   a controller that comprises a first terminal connected to the gate terminal and a second terminal connected to the source terminal, comprises a first switch provided between the first terminal and a voltage source, and a second switch provided between the first terminal and the second terminal, and is configured to switch between the first switch and the second switch to control turning on and off of the first switching element;
   a first resistor and a first capacitor, each having one end connected to the gate terminal and another end connected to the first terminal, the first resistor and the first capacitor being connected in parallel to each other;
   a second capacitor that has one end connected to the source terminal and another end connected to the second terminal; and
   a first Zener diode that has a cathode terminal connected to the source terminal and an anode terminal connected to the second terminal, and is connected in parallel to the second capacitor.

2. The gate drive circuit according to claim 1, wherein a mirror clamp circuit is provided between the gate terminal as one side and the one end of the first resistor and the one end of the first capacitor together as another side, and between the second terminal as one side and the other end of the second capacitor and the anode terminal of the first Zener diode together as another side.

3. The gate drive circuit according to claim 2, wherein

   the mirror clamp circuit comprises a second switching element that is turned on when a voltage vqs between the gate terminal as one side and the one end of the first resistor and the one end of the first capacitor together as another side, and between the second terminal as one side and the other end of the second capacitor and the anode terminal of the first Zener diode together as another side becomes equal to or lower than a threshold voltage Vth, and
   when the first switching element sequentially transitions through a plurality of modes that include a first mode during which an input capacitance of the first switching element is charged and the first switching element is turned on, and a second mode during which the first switch is turned off, the second switch is turned on, and the first switching element is turned off,
   a following mathematical expression is satisfied, where a voltage across and a capacitance of the first capacitance are vcp and Cp, respectively, a voltage across and a capacitance of the second capacitance are vcs and Cs, respectively, a gate charge amount and an input capacitance of the first switching element are Qg and Ciss, respectively, vcp and vcs at an end of the first mode are vcp_1 and vcs_1, respectively, a drain-source voltage of the second switching element at an end of the second mode is Vqs_2, and a voltage across the first capacitor at the end of the second mode is Vcp_2.

   [Mathematical Expression 1]

   $$Vqs\_2 = -Vcp\_2$$
   $$= \frac{Cs[Qg - Vcp\_1 \cdot Cp] + Ciss[Vcs\_1 \cdot Cs - Vcp\_1 \cdot Cp]}{(Cp \cdot Cs + Cs \cdot Ciss + Ciss \cdot Cp)} > Vth$$

4. The gate drive circuit according to any one of claims 1 to 3, further comprising a second resistor having one end connected between the source terminal as one side and the one end of the second capacitor and the cathode terminal of the first Zener diode together as another side, the second resistor having the other end connected to a third terminal of the controller that is directly connected to the voltage source.

5. The gate drive circuit according to any one of claims 1 to 4, further comprising:

   a third resistor having one end connected to the other end of the first capacitor, and the other end connected to the other end of the first resistor; and
   a fourth resistor and a first diode connected in series,
   wherein the fourth resistor has one end connected to the other end of the first capacitor, the other end connected to an anode terminal of the first diode, and the first diode has a cathode terminal connected to the other end of the first resistor.

6. The gate drive circuit according to any one of claims 1 to 5, further comprising a Schottky diode having a cathode terminal connected to the one end of the first resistor and the one end of the first capacitor, and an anode terminal connected to the other end of the second capacitor and the anode terminal of the first Zener diode.

7. The gate drive circuit according to any one of claims 1 to 6, further comprising a second Zener diode having a cathode terminal connected to the one end of the first resistor and the one end of the first capacitor, and an anode terminal connected to the one end of the second capacitor and the cathode terminal of the first Zener diode.

8. A switching circuit comprising:

   a plurality of switching elements connected in series; and
   the gate drive circuit according to any one of claims 1 to 7 as a gate drive circuit that is connected to a gate terminal and a source terminal of each of the switching elements and turns on and off the switching element.

Fig. 1

Fig. 2

Fig. 3

Fig. 4A

Fig. 4B

EP 4 366 147 A1

Fig. 5A

Fig. 5B

EP 4 366 147 A1

Fig. 6B

Fig. 6A

Fig. 7B

Fig. 7A

Fig. 8A

Fig. 8B

Fig. 9

Fig. 10

EP 4 366 147 A1

Fig. 11

Fig. 12A

Fig. 12B

EP 4 366 147 A1

Fig. 13A

Fig. 13B

Fig. 14B

Fig. 14A

Fig. 15A

Fig. 15B

Fig. 16B

Fig. 16A

Fig. 17B

Fig. 17A

Fig. 18

Fig. 19

Fig. 20

Fig. 21

EP 4 366 147 A1

Fig. 22

Fig. 23

Fig. 24

Fig. 25

20S

Q1

vgs

MOSFET Qs

Ds

Cs

Cp

Rp

Fig. 26

Fig. 27

## INTERNATIONAL SEARCH REPORT

International application No.

**PCT/JP2022/013581**

### A. CLASSIFICATION OF SUBJECT MATTER

*H02M 1/08*(2006.01)i; *H02M 3/155*(2006.01)i
FI:  H02M1/08 A; H02M3/155 C

According to International Patent Classification (IPC) or to both national classification and IPC

### B. FIELDS SEARCHED

Minimum documentation searched (classification system followed by classification symbols)

H02M1/08; H02M3/155

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2020-068630 A (OMRON CORP.) 30 April 2020 (2020-04-30) paragraphs [0026]-[0043], fig. 1-4, 6-7, 9-10 | 1-2, 6-8 |
| A | | 3-5 |
| A | JP 2018-033303 A (IHI CORP.) 01 March 2018 (2018-03-01) paragraphs [0018]-[0087], fig. 1-14 | 1-8 |
| A | JP 2019-004636 A (DENSO CORP.) 10 January 2019 (2019-01-10) paragraphs [0037]-[0047], fig. 9-13 | 5 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **09 May 2022** | **17 May 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/013581**

| Patent document cited in search report | | | Publication date (day/month/year) | Patent family member(s) | | Publication date (day/month/year) |
|---|---|---|---|---|---|---|
| JP | 2020-068630 | A | 30 April 2020 | EP 3832864 A1 paragraphs [0026]-[0071], fig. 1-4, 6-7, 9-10 WO 2020/084807 A1 CN 112585854 A | | |
| JP | 2018-033303 | A | 01 March 2018 | (Family: none) | | |
| JP | 2019-004636 | A | 10 January 2019 | (Family: none) | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013099133 A

- JP 2014093586 A